# EUROPEAN PATENT SPECIFICATION

(11) **EP 0 542 581 B1**
(45) Date of publication and mention of the grant of the patent: **17.07.1996**
(21) Application number: 92310454.1
(22) Date of filing: 16.11.1992
(51) Int. Cl.: H01L 31/0232, H01L 31/0216

(54) **Solid state image pickup apparatus having microlenses**
Festkörperbildaufnahmevorrichtung mit Mikrolinsen
Capteur d'image à l'état solide ayant des microlentilles

(30) Priority: 15.11.1991 JP 300668/91
(43) Date of publication of application: 19.05.1993
(73) Proprietor: SHARP KABUSHIKI KAISHA, Osaka 545 (JP)
(72) Inventor: Koyama, Eiji, Tenri-shi, Nara-ken (JP)
(74) Representative: Brown, Kenneth Richard

(56) References cited:
- EP-A- 0 242 663
- EP-A- 0 441 594
- EP-A- 0 444 212
- US-A- 4 667 092
- IEEE TRANSACTIONS ON CONSUMER ELECTRONICS vol. 37, no. 3, August 1991, NEW YORK US pages 487 - 492 SAKAKIBARA ET AL. 'A 1" FORMAT 1.5M PIXEL IT-CCD IMAGE SENSOR FOR AN HDTV CAMERA'

## Description

### BACKGROUND OF THE INVENTION

The present invention generally relates to a solid-state image pickup apparatus having a microlens.

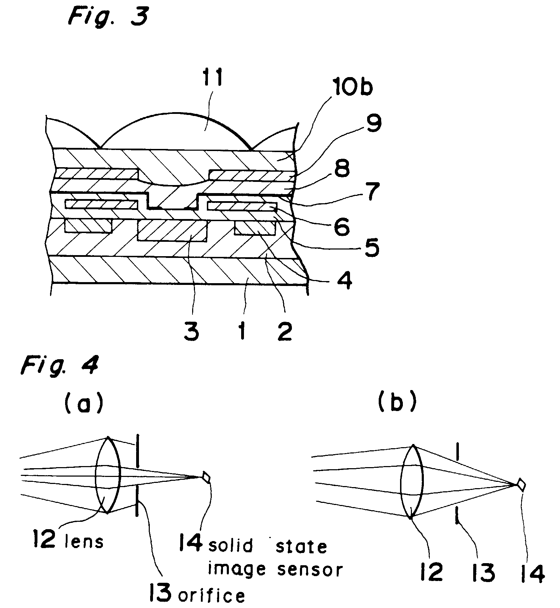

A structural sectional view of the conventional solid-state image pickup apparatus will be described with reference to Fig. 3. A light receiving portion 3 and a transfer portion 4 are provided on the surface portion of a P well region 2 on an N type semiconductor basic plate 1 as shown in Fig. 3. A silicon oxide film 5 is deposited in these upper positions. A polysilicon electrode 6 is provided in the upper portion thereof. The silicon oxide film 5 is deposited even on the polysilicon electrode 6. A tungsten silicide film 7 is provided in the upper portion thereof. A BPSG film 8 is deposited in the upper portion of the tungsten silicide film 7. A light-screening metal 9 is provided in the upper portion thereof so that light is not projected into the transfer portion 4. A flattening film 10b is provided thereon as an acrylic resin or the like.

A microlens 11 is provided on the above-described flattening film 10b by the use of a transparent resin being almost the same in refractive index as that of the flattening film material so as to improve the usage ratio of the incident light. Therefore, a substantial opening ratio is achieved.

Fig. 4 shows a sectional view of an optical system mechanism such as a camera. In Fig. 4, reference numeral 12 denotes an optical system lens, reference numeral 13 an iris, and reference numeral 14 a solid-state image pickup apparatus.

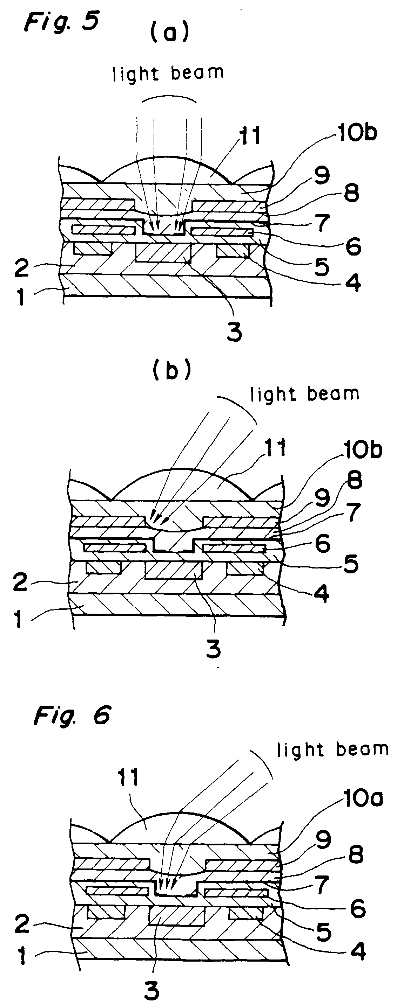

A solid-state image pickup apparatus 14 is positioned, as shown in Fig. 4, in a location where light is gathered by the optical system lens 12 to form an image. An image is formed as shown in Fig. 4 (a), (b) with the size of the opening portion of the iris 13 in this case. In the case of Fig. 4 (a), light is collected onto the light-receiving portion 3 as shown in the incident light passage of Fig. 5 (a). An image-forming position of the microlens 11 is moved sideways from the light-receiving portion 3 because of obliquely incident light, as shown in the incident light passage of Fig. 5 (b), in a condition with the iris being opened as shown in Fig. 4 (b). As the opening portion of the iris 13 becomes larger like this, the light collecting ratio by the microlens 11 is reduced.

US-A-4 667 092 discloses a solid-state image device having a plurality of storage elements embedded in a block surface which store an image in the form of electric charge. An overlying layer of optical lenses in correspondence to the storage elements, is provided. An intermediate layer which serves to adjust the focal length of the lenses and having the same refractive index as that of the lenses is disposed between the lens layer and the block surface.

### SUMMARY OF THE INVENTION

In one aspect the present invention, as defined by claim 1, provides a solid-state image pickup device comprising an array of photosensitive elements formed in a semiconductor structure, a flattening film formed over said semiconductor structure, and an array of microlenses formed over said flattening film, wherein the refractive index of the flattening film is larger than that of the microlenses.

According to the invention the solid-state image pickup device is improved in its light-collection efficiency since, as shown in Fig. 6, light rays obliquely incident on the microlens become more orthogonal than before with respect to the light-receiving face.

In another aspect the present invention, as defined by claim 3, provides a processing for manufacturing this solid-state image pickup device.

### BRIEF DESCRIPTION OF THE DRAWINGS

Fig. 1 is a structural sectional view of one embodiment of the present invention;
Fig. 2 illustrates a manufacturing process of one embodiment of the present invention;
Fig. 3 is a structural sectional view of a conventional solid-state image pickup apparatus;
Fig. 4 is a sectional view of an optical system mechanism such as a camera;
Fig. 5 is an incident light passage view of the conventional solid-state image pickup apparatus in a mechanism shown in Fig. 4;
Fig. 6 is an incident light passage view of a solid image pickup apparatus of the embodiment of the present invention in a mechanism shown in Fig. 4; and
Fig. 7 (a) to (c) are graphs showing light rays incident on a photo diode in relation to the refractive indices of a coated film and a microlens.

### DETAILED DESCRIPTION OF THE PREFERRED EMBODIMENT

Like parts are designated by like reference numerals throughout the accompanying drawings.

The present invention will be described hereinafter in detail in accordance with one embodiment.

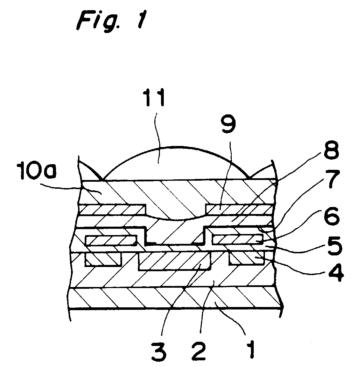

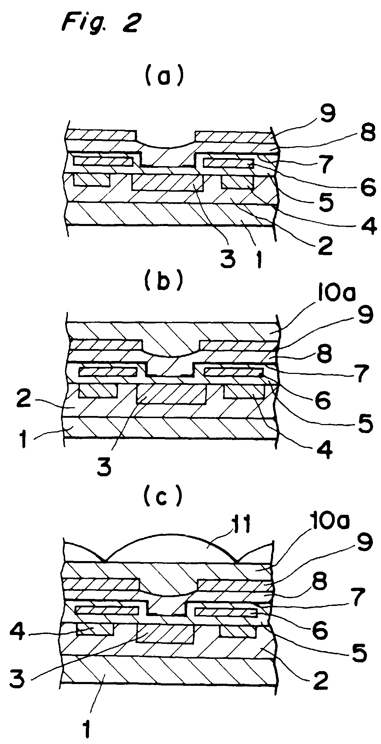

Fig. 1 is a structural sectional view of one embodiment of the present invention. Fig. 2 illustrates a manufacturing process of one embodiment of the present invention. In Fig. 1 and Fig. 2, reference numeral 1 denotes an N type semiconductor basic plate, reference numeral 2 a P well layer, reference numeral 3 a light-receiving portion, reference numeral 4 a transfer portion, reference numeral 5 a silicon oxide film, reference numeral 6 a polysilicon electrode, reference numeral 7 a tungsten silicide film, reference numeral 8 a BPSG film, reference numeral 9 a light-screening film, reference numeral 10a a flattening film whose refractive index is larger than the refractive index of a microlens material, and reference numeral 11 a microlens.

The present invention is characterized in that a flattening film 10a is formed of a material having a refractive index larger than that of the microlens 11.

A manufacturing process will be described hereinafter with reference to Fig. 2.

By the conventional art, a P well layer 2 is formed on anN type semiconductor basic plate 1. A light-receiving portion 3 and a transfer portion 4 are formed on the surface portion of the P well layer 2. Thereafter, a silicon oxide film 5 is deposited, and a polysilicon electrode 6 is formed. Then, the silicon oxide film 5 is deposited again as the polysilicon electrode 6 is covered. The tungsten silicide film 7 is formed in the upper portion of the above described electrode 6. An aluminium silicide film is formed as a light-screening film 9 after the BPSG film 8 has been deposited. (See Fig. 2a).

A material having a high refractive index such as a polyamide resin is applied as a flattening film material by a spin-coating method. It is baked for 5 through 10 minutes at 200°through 250°C so as to form a flattening film 10a (Fig. 2b). The flattening film material has only to be larger in refractive index than the microlens material without restriction to the present invention. Also, the film thickness is different in element. In the spin-coating method, the high refractive index material is applied by a coater at a certain atmosphere of temperature and humidity being constant under controlling severely the dropping amount, number and time of revolutions and others in order to obtain a predetermined thickness of the coated film. Then, it is applied to post-bake aimed at drying. Since it is difficult to plateau completely the unevenness of the surface as it is, the spin-coating process is repeated many times to improve the evenness of the coated film. Normally, two times of spin-coating can fairly improve the evenness of coated film, and the sum of the film thicknesses becomes the film thickness of the evenned film. In addition to the spin-coating method, there is another method of etching back the material which is coated in thickness to eliminate the effect of unevenness of the surface, and then plasma-etching the surface of material to provide the evenned film.

Acrylic resin, or the like, whose refractive index is 1 or larger is coated as a lens material by a spin-coating method in the same manner of coating the evenned film. It is patterned by a photoetching process. At this time of applying the spin-coating method, it is necessary to control severely the dropping amount, number and time of revolutions and others in order to obtain a predetermined thickness of the coated film. Thereafter, there are applied steps to expose and develop the coated film to do patterning. Next, the patterned film is melted at 150° through 160°C. It is necessary to control severely the pattern of the coated film, and the temperature, time, humidity and others of melting so as to obtain the ideal shape of lens. Then, the film is dried so as to form a microlens 11. (Fig. 2c)

With the above process, the coated film and lens material are employed to use the thermoplasticity of resin; other kinds of resin having thermoplasticity can also be applied to the process, for instance, acrylic resin having 1.5 refractive index, polymidic resin having 1.8 refractive index, novolac resin having 2.6 refractive index, and others.

The following equation will be established by optical rules in the relationship between the radius of curvature γ and focus distance f with respect to the refractive index N₀ of air, the refractive indices N₁ of the coated film and microlens.$\text{f} \text{=} \frac{{\text{N}}_{\text{1}}}{{\text{N}}_{\text{1}} {\text{-N}}_{\text{0}}} \text{·γ}$

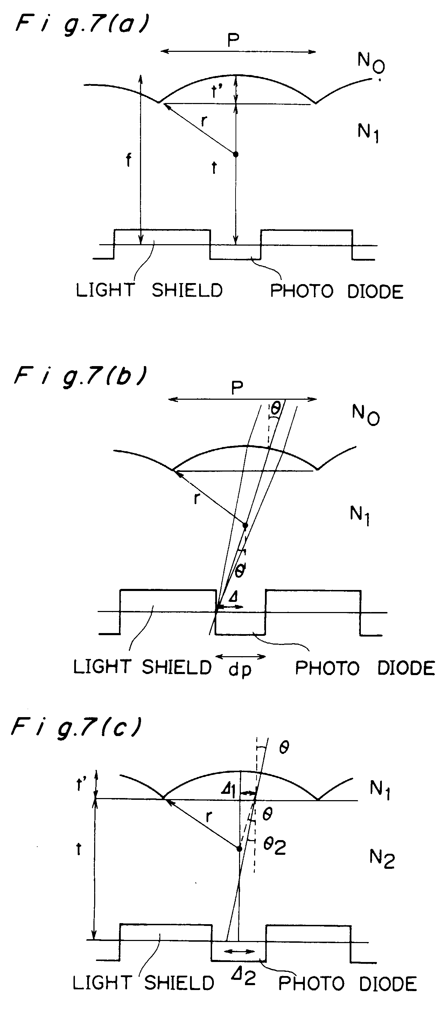

If the focus is set up in imagery on the surface of a photodiode, the following equation (1) will be established in connection with the picture element pitch P, thickness of the coated film t, and height of the microlens t', as shown in Fig. 7 (a).${\text{γ}}^{\text{2}} \text{= (} \text{P} {\text{/2)}}^{\text{2}} \text{+ (γ-} \text{t'} {\text{)}}^{\text{2}} \text{,}$$\text{f = t+t'}$ *then,*$\text{t} \text{=} \frac{{\text{N}}_{\text{1}}}{{\text{N}}_{\text{1}} {\text{-N}}_{\text{0}}} \text{{} \frac{{\left(\text{P} \text{/2}\right)}^{2} \text{+} {\text{t'}}^{\text{2}}}{\text{2} \text{t'}} \text{}-} \text{t'}$ With the above equation (1), when the materials of the coated film and microlens and the refractive index N₁ are decided in accordance with the element pitch, the lens forming is done by the values of t and t' satisfying the equation (1) to have the imagery of focus on the surface of the photodiode. In other words, if the condition of equation (1) is satisfied, there is no limitation for the value of N₁. However, the above assumption for the equation (1) is established in the case of incident ray being normally incident vertically with respect to the microlens, whereas, if the diaphragm of the iris is going to open, it is incident with a certain angle to the microlens.

As shown in Fig. 7 (b), if the light ray is incident with an angle of θ with respect to the photo diode, the aberration Δ of focus will be presented by the following equation.$\text{Δ=(} \text{f} \text{-γ)·sinθ=} \frac{{\text{N}}_{\text{0}}}{{\text{N}}_{\text{1}} {\text{-N}}_{\text{0}}} \text{·γ·sinθ,}$ *wherein*$\text{γ=} \frac{{\left(\text{P} \text{/2}\right)}^{2} \text{+} {\text{t'}}^{\text{2}}}{\text{2} \text{t'}}$ *then*,$\text{Δ=} \frac{{\text{N}}_{\text{0}}}{{\text{N}}_{\text{1}} {\text{-N}}_{\text{0}}} \text{{} \frac{{\left(\text{P} \text{/2}\right)}^{2} \text{+} {\text{t'}}^{\text{2}}}{\text{2} \text{t'}} \text{} ·sinθ}$ If the opening efficiency of photo diode is α and the opening is αP, the following equation is established.$\text{Δ ≤} \frac{\text{α} \text{P}}{\text{2}}$

When the above equation is established, the converging efficiency becomes lower even with the incident ray having the angle of θ, which may be 30° in the case of wide angle lens, and may be changed to the value of 0.25 to 0.3 according to the variation of the value α.

Consequently, when the lens system is formed with the thicknesses t and t' of coated film and microlens which satisfy the following equation (2), there is no limitation on the value of N₁.$\text{t} \text{=} \frac{{\text{N}}_{\text{1}}}{{\text{N}}_{\text{1}} {\text{-N}}_{\text{0}}} \text{·} \frac{{\left(\text{P} \text{/2}\right)}^{2} \text{+} {\text{t'}}^{\text{2}}}{\text{2} \text{t'}} \text{-} \text{t'} \frac{{\text{N}}_{\text{0}}}{{\text{N}}_{\text{1}} {\text{-N}}_{\text{0}}} \text{{} \frac{{\left(\text{P} \text{/2}\right)}^{2} \text{+} {\text{t'}}^{\text{2}}}{\text{2} \text{t'}} \text{}·sinθ≤α} \text{P} \text{/2}$

With the above condition of equation (2), if the coated film has the refractive index N₂ (N₂>N₁), the aberration Δ' of focus is explained by the following equation (3).${\text{Δ'=-Δ}}_{\text{1}} {\text{+Δ}}_{\text{2}} \text{=-(γ-} \text{t'} \text{) ·sinθ+} \text{t} {\text{·sinθ}}_{\text{2}} \text{=-(γ-} \text{t'} \text{) ·sinθ+} \text{t} \frac{{\text{N}}_{\text{1}}}{{\text{N}}_{\text{2}}} \text{sinθ}$ Therefore,$\text{Δ'= {(} \frac{{\text{N}}_{\text{1}}}{{\text{N}}_{\text{1}} {\text{-N}}_{\text{0}}} \text{·} \frac{{\left(\text{P} \text{/2}\right)}^{2} \text{+} {\text{t'}}^{\text{2}}}{\text{2} \text{t'}} \text{-} \text{t'} \text{)} \frac{{\text{N}}_{\text{1}}}{{\text{N}}_{\text{2}}} \text{-} \frac{{\left(\text{P} \text{/2}\right)}^{2} \text{-} {\text{t'}}^{\text{2}}}{\text{2} \text{t'}} \text{}·sinθ}$ Accordingly,$\text{Δ'≤α} \text{P} \text{/2}$$\text{Δ'-Δ=2} \text{t'} \text{sinθ{(} \text{P} {\text{/2)}}^{\text{2}} \frac{{\text{N}}_{\text{1}} \left({\text{N}}_{\text{1}} {\text{-N}}_{\text{2}}\right)}{{\text{N}}_{\text{2}} \left({\text{N}}_{\text{1}} {\text{-N}}_{\text{0}}\right)} \text{+} \frac{\left({\text{N}}_{\text{1}} {\text{-N}}_{\text{2}}\right) \left(\text{2} {\text{N}}_{\text{0}} {\text{-N}}_{\text{1}}\right)}{\left({\text{N}}_{\text{1}} {\text{-N}}_{\text{0}}\right) {\text{N}}_{\text{2}}} {\text{·t'}}^{\text{2}} \text{}} \text{=2} \text{t'} \text{sinθ·} \frac{{\text{N}}_{\text{1}} {\text{-N}}_{\text{2}}}{{\text{N}}_{\text{2}} \left({\text{N}}_{\text{1}} {\text{-N}}_{\text{0}}\right)} \text{{} {\text{N}}_{\text{1}} \text{(} \text{P} {\text{/2)}}^{\text{2}} \text{+(2} {\text{N}}_{\text{0}} \text{-} {\text{N}}_{\text{1}} \text{)} {\text{t'}}^{\text{2}} \text{}}$ If the condition that N₀=1, N₁=1.5, N₂ > N₁ is established, the condition of Δ'-Δ < 0 is always maintained, whereby it is possible to depress the aberration of focus by any means.

As it is clear from the foregoing description, according to the arrangement of the present invention, the lateral shift in the image-forming position by the microlens becomes smaller than the conventional shift, as described in detail, by the use of the present invention so that the reduction in the light collecting ratio caused by the oblique incident light can be prevented from occurring.

## Claims

1. A solid-state image pickup device comprising an array of photosensitive elements (3) formed in a semiconductor structure (1 to 9), a flattening film (10a) formed over said semiconductor structure, and an array of microlenses formed over said flattening film, characterized in that the refractive index of the flattening film is larger than that of the microlenses.

2. A solid-state image pickup device according to claim 1, wherein said flattening film (10a) comprises polyamide resin and said microlenses (11) comprise acrylic resin.

3. A process of manufacturing the solid-state image pickup device defined by claim 2, comprising:
forming said semiconductor structure having said array of photosensitive elements;
depositing a polyamide resin on said semiconductor structure using a spin-coating method;
baking the deposited polyamide resin for 5 through 10 minutes at 200°C through 250°C to form said flattening film;
depositing an acrylic resin on said flattening film using a spin-coating method; and
forming said microlenses, at positions disposed above said photosensitive elements, from the deposited acrylic resin.

## Patentansprüche

1. Festkörper-Bildaufnabmevorrichtung mit einem Array photoempfindlicher Elemente (3), das in einer Halbleiterstruktur (1 bis 9) ausgebildet ist, einem auf der Halbleiterstruktur ausgebildeten Einebnungsfilm (10a) und einem auf dem Einebnungsfilm ausgebildeten Mikrolinsenarray, **dadurch gekennzeichnet**, daß der Brechungsindex des Einebnungsfilms größer als der der Mikrolinsen ist.

2. Festkörper-Bildaufnahmevorrichtung nach Anspruch 1, bei der der Einebnungsfilm (10a) aus Polyamidharz und die Mikrolinsen (11) aus Acrylharz bestehen.

3. Verfahren zum Herstellen der durch Anspruch 2 definierten Festkörper-Bildaufnahmevorrichtung, umfassend:
- Herstellen der Halbleiterstruktur mit dem Array photoempfindlicher Elemente;
- Abscheiden eines Polyamidharzes auf der Halbleiterstruktur unter Verwendung eines Schleuderbeschichtungsverfahrens;
- Brennen des abgeschiedenen Polyamidharzes für 5 bis 10 Minuten bei 200°C bis 250°C, um den Einebnungefilm herzustellen;
- Abscheiden eines Acrylharzes auf dem Einebnungsfilm unter Verwendung eines Schleuderbeschichtungsverfahrens; und
- Herstellen der Mikrolinsen an über den photoempfindlichen Elementen liegenden Positionen auf dem abgeschiedenen Acrylharz.

## Revendications

1. Dispositif capteur d'images à solide comprenant une matrice d'éléments photosensibles (3) formée dans une structure à semiconducteur (1 à 9), un film d'égalisation (10a) formé par dessus ladite structure à semiconducteur, et une matrice de microlentilles formée par dessus ledit film d'égalisation, caractérisé en ce que l'indice de réfraction du film d'égalisation est plus élevé que celui des microlentilles.

2. Dispositif capteur d'images à solide selon la revendication 1, dans lequel ledit film d'égalisation (10a) comprend une résine polyamide et lesdites microlentilles (11) comprennent une résine acrylique.

3. Procédé de fabrication du dispositif capteur d'images à solide défini par la revendication 2, comprenant:
la réalisation de ladite structure à semiconducteur comportant ladite matrice d'éléments photosensibles;
le dépôt d'une résine polyamide sur ladite structure à semiconducteur, par mise en oeuvre d'une technique d'enduction à la tournette;
la cuisson de la résine polyamide déposée pendant 5 à 10 minutes à une température de 200°C à 250°C, pour la formation dudit film d'égalisation;
le dépôt d'une résine acrylique sur ledit film d'égalisation, par mise en oeuvre d'une technique d'enduction à la tournette; et
la réalisation desdites microlentilles à partir de la résine acrylique déposée, en des points situés au-dessus desdits éléments photosensibles.
